# FASCICULE DE BREVET EUROPEEN

(11) **EP 1 317 003 B1**
(45) Date de publication et mention de la délivrance du brevet: **16.07.2008**
(21) Numéro de dépôt: 02292822.0
(22) Date de dépôt: 13.11.2002
(51) Int. Cl.: H01L 31/0203, H01L 27/146

(54) **Boîtier semi-conducteur à capteur, muni d'un insert de fixation**
Gehäuse mit Befestigungseinsatz für Halbleitersensor
Packaging with fixing insert for a semiconductor sensor

(30) Priorité: 14.11.2001 FR 0114739
(43) Date de publication de la demande: 04.06.2003
(73) Titulaire: STMicroelectronics S.A., 92120 Montrouge (FR)
(72) Inventeur: Prior, Christophe, 38420 Le Versoud (FR)
(74) Mandataire: Casalonga, Axel

(56) Documents cités:
- EP-A- 0 313 174
- EP-A- 0 398 575
- EP-A- 0 450 560
- US-A- 4 622 580
- US-A- 5 098 630
- US-A- 5 289 002

## Description

La présente invention concerne le domaine des boîtiers semi-conducteurs présentant un capteur, en particulier un capteur optique, chimique, de déplacement, agissant à distance ou par contact.

Dans la technique actuelle, les boîtiers semi-conducteurs à capteurs, généralement optiques, comprennent une plaque de support et de connexion électrique sur la face avant de laquelle est fixée la face arrière d'un composant semi-conducteur par l'intermédiaire d'une couche de colle, ainsi qu'un système optique placé en avant et à distance de la face avant, munie d'un capteur, du composant semi-conducteur.

Par ailleurs, le brevet US-A-5 098 630 décrit un boîtier dans lequel un composant semi-conducteur est fixé au fond d'un évidemment d'une plaque de support et de connexion électrique, après quoi on installe des fils de connexion électrique du composant à la plaque, ces fils passant au-dessus d'un espace séparant la périphérie du composant et la périphérie de l'évidemment et un moule un bloc d'encapsulation dans lequel sont noyés les fils et qui remplit ledit espace.

Les dispositions connues posent en général des problèmes de positionnement du système optique par rapport au capteur optique du composant semi-conducteur du fait des empilages des tolérances de fabrication.

Afin de tenter de remédier en particulier à ces difficultés, la présente invention propose un boîtier semi-conducteur qui, d'une manière générale, comprend des moyens de support et de connexion électrique présentant, dans une face avant, un évidement et un composant semi-conducteur placé dans ledit évidemment et dont une face avant comprend un capteur, un espace séparant la périphérie dudit composant semi-conducteur et la périphérie dudit évidemment.

Selon l'invention, le boîtier comprend des moyens de positionnement et de blocage dudit composant semi-conducteur sur lesdits moyens de montage et de connexion, engagés dans ledit espace et permettant de maintenir la face arrière dudit composant semi-conducteur en appui contre le fond dudit évidement.

Selon l'invention, lesdits moyens de positionnement et de blocage peuvent avantageusement comprendre au moins un insert coopérant avec la partie périphérique dudit composant semi-conducteur et la partie périphérique dudit évidement.

Selon l'invention, lesdits moyens de positionnement et de blocage peuvent avantageusement comprendre au moins une partie engagée dans au moins un trou ménagé dans le fond dudit évidement. Selon l'invention, lesdits moyens de positionnement et de blocage peuvent avantageusement comprendre une partie latérale en appui sur la face avant dudit composant semi-conducteur.

Selon l'invention, lesdits moyens de positionnement et de blocage peuvent avantageusement comprendre une partie latérale en appui sur la face avant desdits moyens de support et de connexion.

Selon une variante de l'invention, lesdits moyens de positionnement et de blocage comprennent au moins un insert auto-bloqué par coincement dans ledit espace.

Selon une autre variante de l'invention, lesdits moyens de positionnement et de blocage comprennent au moins un insert collé auxdits moyens de montage et de connexion.

Selon l'invention, une couche de colle est de préférence interposée entre ladite partie latérale et ladite face avant dudit composant semi-conducteur et/ou desdits moyens de support et de connexion.
Selon une variante de l'invention, lesdits moyens de positionnement et de blocage comprennent un insert annulaire auto-bloqué par coincement dans un espace annulaire séparant la périphérie dudit composant semi-conducteur et la périphérie dudit évidement.

Selon l'invention, la paroi périphérique dudit évidement est de préférence en contre-dépouille. Selon l'invention, ledit insert peut avantageusement être en un matériau élastique.

Selon l'invention, des moyens d'encapsulation de la face avant dudit composant semi-conducteur sont prévus.

Selon l'invention, lesdits moyens d'encapsulation peuvent avantageusement comprendre une bague fixée sur la face avant desdits moyens de support et de connexion et une plaque en un matériau transparent située à distance de la face avant dudit composant semi-conducteur et fixée sur ladite bague.

Selon l'invention, lesdits moyens d'encapsulation peuvent avantageusement comprendre une plaque en un matériau transparent placée à distance de la face avant dudit composant semi-conducteur et fixée sur lesdits moyens de positionnement et de blocage.

La présente invention sera mieux comprise à l'étude de boîtiers semi-conducteurs à capteurs optiques, décrits à titre d'exemples non limitatifs et illustrés par le dessin sur lequel :
- la figure 1 représente une coupe transversale médiane selon I-I de la figure 2 d'un premier boîtier semi-conducteur selon la présente invention selon I-I de la figure 2 ;
- la figure 2 représente une vue de dessus du boîtier semi-conducteur de la figure 1 ;
- la figure 3 représente une coupe transversale médiane du boîtier semi-conducteur des figures 1 et 2, dans une première étape intermédiaire de fabrication ;
- la figure 4 représente une coupe transversale médiane du boîtier semi-conducteur des figures 1 et 2, dans une seconde étape intermédiaire de fabrication ;
- la figure 5 représente, selon une coupe brisée V-V de la figure 6, un second boîtier semi-conducteur selon la présente invention ;
- la figure 6 représente une vue de dessus du boîtier semi-conducteur de la figure 5 ;
- La figure 7 représente, selon une coupe brisée VII-VII de la figure 8, un troisième boîtier selon la présente invention ;
- et la figure 8 représente une vue de dessus du boîtier semi-conducteur de la figure 7.

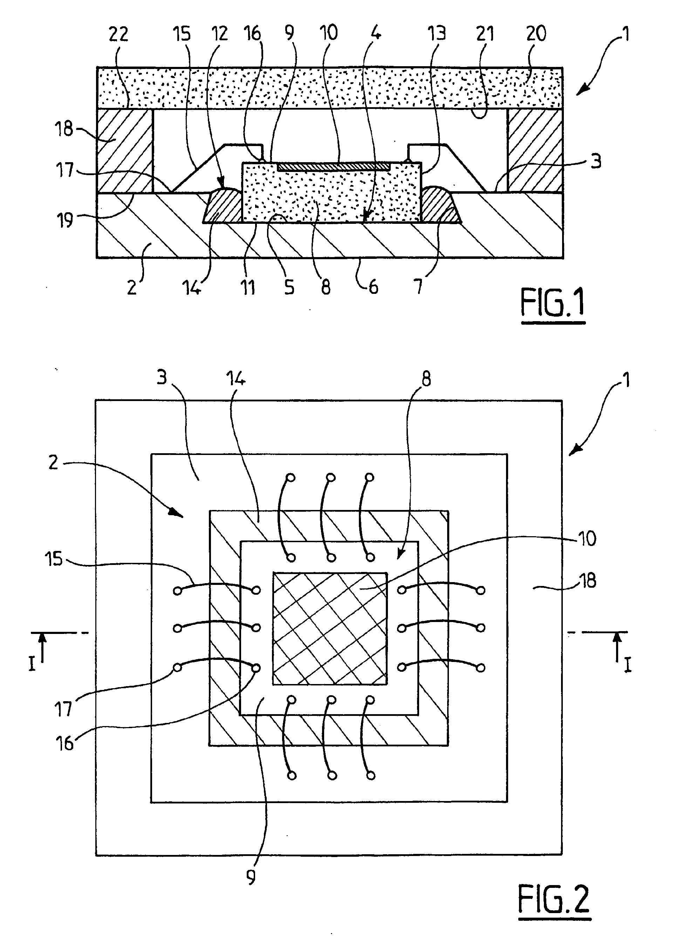

En se reportant aux figures 1 et 2, on a représenté un boîtier semi-conducteur 1 qui comprend une plaque 2 de support et de connexion électrique qui présente une face avant 3 dans laquelle est ménagé un évidement 4 à fond plat 5 parallèle à la face arrière 6 de la plaque 2 et quatre parois latérales 7 en contre-dépouille.

Le boîtier semi-conducteur 1 comprend un composant semi-conducteur 8 de forme parallèlépipédique, dont la face avant 9 présente, dans sa partie centrale, un capteur optique 10 et dont la face arrière 11 est en appui sur le fond 5 de l'évidement 4 de la plaque 2, le composant semi-conducteur 8 étant placé dans la partie centrale de l'évidement 4 de manière à laisser subsister un espace annulaire 12 entre sa paroi périphérique 13 et la paroi périphérique 7 de l'évidement 4.

A titre d'exemple, l'épaisseur du composant semi-conducteur 8 est supérieure à la profondeur de l'évidement 4 de telle sorte qu'il dépasse vers l'avant.

Dans l'espace annulaire 12 est disposé un insert annulaire 14 de blocage et de maintien du composant semi-conducteur 8 dans l'évidement 4 et en appui contre le fond 5 de ce dernier.

Le boîtier semi-conducteur 1 comprend en outre des fils de connexion électrique 15 dont les extrémités sont reliées d'une part à des plots de connexion électrique 16 prévus sur la face frontale 9 du composant semi-conducteur 8, à la périphérie et à distance du capteur optique 10, et d'autre part à des plots de connexion électrique 17 prévus sur la face avant 3 de la plaque 2, par exemple à mi-distance entre le bord périphérique de l'évidement 5 et le bord périphérique de cette plaque.

La plaque de support et de connexion électrique 2 peut être en un matériau isolant multi-couches intégrant des pistes et des vias de connexion électrique pour relier les plots frontaux 17 à des plots de connexion électrique prévus en particulier sur sa face arrière 6. Dans une variante, la plaque de support et de connexion électrique 2 pourrait être métallique et porter sur sa face frontale 3, sur ses faces latérales et/ou sa face arrière 6 des pistes de connexion électrique isolées formées sur une couche intermédiaire en un matériau isolant.

Le boîtier semi-conducteur 1 comprend également une bague périphérique rapportée 18 dont la face arrière 19 est fixée sur la périphérie de la plaque 2 par exemple par collage, extérieurement aux plots de connexion électrique 17, ainsi qu'une plaque 20 en un matériau transparent tel que du verre, dont la périphérie de la face arrère 21 est fixée sur la face avant 22 de la bague 18, la plaque transparente 20 s'étendant en avant du composant semi-conducteur 8 et des fils de connexion électrique 15 de façon à constituer des moyens d'encapsulation.

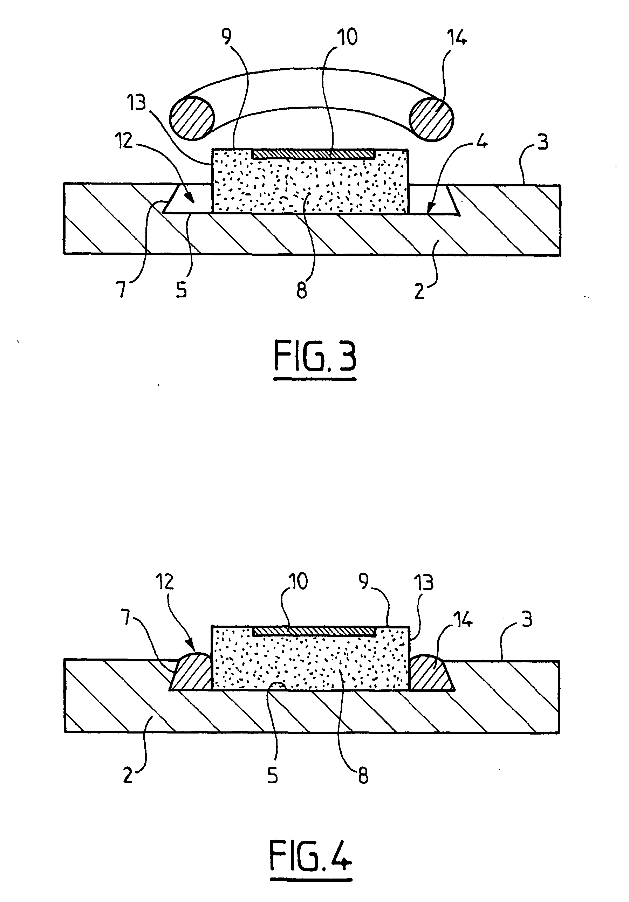

Le boîtier semi-conducteur 1 peut être fabriqué de la manière suivante.
Comme le montre la figure 3, disposant de la plaque de support et de connexion électrique 2 présentant l'évidement 4 et grâce à tous moyens connus de transfert et d'appui non représentés, on installe le composant semi-conducteur optique 8 au centre de l'évidement 4, de telle sorte que sa face arrière 11 soit en appui contre le fond 5 de l'évidement 4, et on le maintient.

Comme le montre la figure 4, à l'aide de moyens de transfert appropriés non représentés, on prend un insert annulaire 14, par exemple préformé en correspondance avec l'espace annulaire 12 et constitué en un matériau élastique tel qu'en silicone, et on l'engage à force dans l'espace annulaire 12 de telle sorte qu'il vienne remplir cet espace en exerçant une pression contre le fond 5 et la paroi latérale 7 de l'évidement 4 et contre la paroi périphérique 13 du composant semi-conducteur 8 en direction du fond 5 de l'évidement 4.

En variantes de réalisation, on pourrait prévoir que l'insert de positionnement et de maintien 14 pourrait être constitué par une matière thermo-plastique ou un cordon de gel déposé tel qu'un gel de silicone, que l'on ferait durcir en plaçant le montage sous une source chaude.

Ensuite, on procède à l'installation des fils de connexion électrique 15 et de la bague 18, ou inversement. Enfin, on fixe la plaque transparente 20 sur la bague 18.

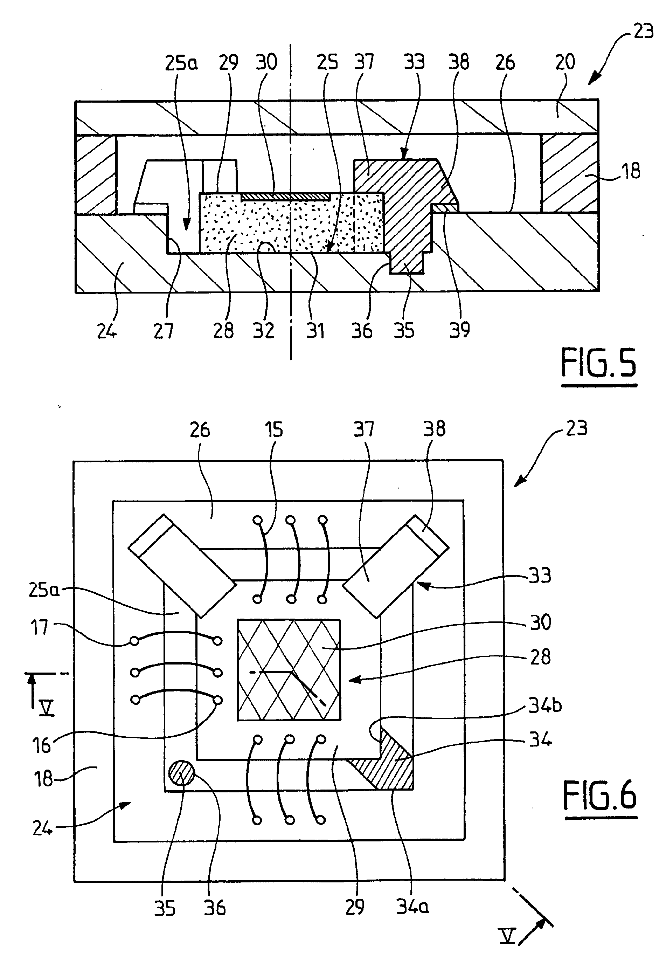

En se reportant aux figures 5 et 6, on voit qu'on a représenté un boîtier semi-conducteur 23 qui se différencie de celui décrit en référence aux figures 1 à 4 par le fait que sa plaque de support et de connexion électrique 24 présente un évidement 25 dans sa face avant 26, les flancs ou parois latérales 27 de cet évidement 25 étant droits.

Le boîtier semi-conducteur 23 s'en différencie également par le fait que son composant semi-conducteur optique 28, dont la face avant 29 présente un capteur optique 30 et dont la face arrière 31 est en appui contre le fond 32 de l'évidement 25, est maintenu en position et bloqué par quatre inserts locaux 33 disposés entre les coins du composant semi-conducteur 28 et ceux de l'évidement 25.

Plus particulièrement, chaque insert 33, par exemple en une matière thermo-plastique tel qu'un polymère technique à haut point de fusion, en particulier supérieur à 300 dégrés celsius, comprend une partie centrale 34 engagée dans l'espace annulaire 25a entre le composant semi-conducteur 28 et la paroi périphérique 27 de l'évidement 25. Cette partie centrale 34 présente une nervure extérieure 34a qui épouse le coin concave de l'évidement 25 et une rainure intérieure 34b qui épouse le coin convexe du composant semi-conducteur 28.

Chaque insert 33 comprend également une partie en saillie 35 formée en-dessous de sa partie centrale 34 et de section circulaire, cette partie en saillie 35 étant engagée dans un trou circulaire 36 ménagé dans le fond 32 de l'évidement 25.

Chaque insert 33 comprend en outre une partie latérale intérieure 37 qui s'étend en avant du composant semi-conducteur 28 et qui est en appui sur un coin de la face avant 29 et une partie latérale extérieure 38 qui s'étend en avant de la face avant 26 de la plaque de support et de connexion 24, dans le voisinage du coin de son évidement 25, une couche de colle 39 étant interposée entre la partie latérale extérieure 38 et la face avant 26 de la plaque de support et de connexion électrique 24.

Dans une variante, les parties centrales 34 des quatre inserts de positionnement et de blocage 33 peuvent être dimensionnées de manière à être en appui contre les coins du composant semi-conducteur 28 et de l'évidement 25 de la plaque de support et de connexion électrique 24.

Dans une autre variante, les parties 34 des inserts de positionnement et de blocage 33 peuvent laisser un jeu entre elles et les coins du composant semi-conducteur 28 et/ou les coins de l'évidement 25 de la plaque de positionnement et de connexion électrique 24.

Dans une autre variante, les flancs 27 de l'évidement 25 de la plaque de support et de connexion électrique 24 pourraient être inclinés de façon à constituer un évidement 25 en forme d'auge et les flancs de la nervure extérieure 34a de la partie centrale 34 des inserts de positionnement et de blocage 33 pourraient aussi être inclinés de façon correspondante et un jeu pourrait être prévu entre la rainure intérieure 34a des parties centrales 34 des inserts 33 et des coins du composant semi-conducteur 28, de façon à produire un effet de levier supplémentaire d'application de la partie latérale intérieure 37 sur la surface frontale 29 du composant semi-conducteur 28.

Pour exécuter le montage du boîtier semi-conducteur 23, on peut procéder de la manière suivante.

On installe au centre et on maintient le composant semi-conducteur 28 dans l'évidement 25 de la plaque de support et de connexion électrique 24.

On dépose quatre couches de colle 39 sur la face frontale 26 de la plaque de support et de connexion électrique 24 sur les zones adjacentes à son évidement 25 et on engage les quatre inserts 33 jusqu'à les amener dans leur position montée décrite précédemment. Les couches de colle 39 étant durcies, on installe les fils électriques 25 et on monte la bague périphérique 18 et la plaque frontale transparente 20 comme dans l'exemple décrit précédemment.

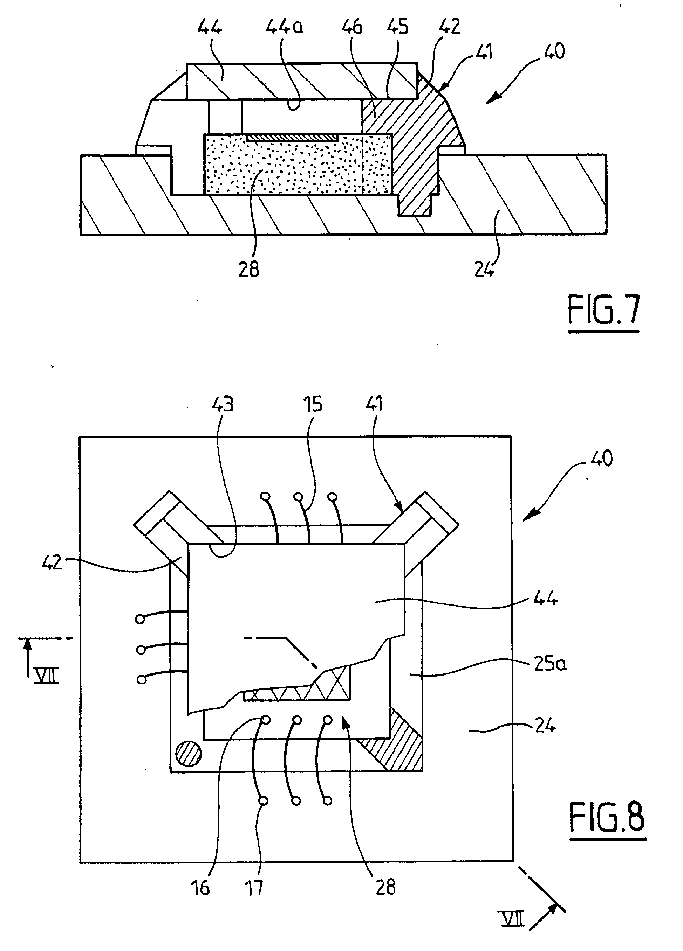

En se reportant aux figures 7 et 8, on voit qu'on a représenté un boîtier semi-conducteur 40 qui se différencie du boîtier semi-conducteur décrit en référence aux figures 5 et 6 uniquement par le fait que la bague périphérique 18 et la plaque transparente 20 sont supprimées et par le fait que sont prévus des inserts locaux 41, par ailleurs identiques aux inserts locaux 33 de l'exemple précédent, qui présentent des parties frontales en saillie 42 qui déterminent des nervures intérieures 43.

Le boîtier semi-conducteur 40 comprend une plaque 44 en un matériau transparent dont la face arrière 44a vient en appui contre les faces avant 45 des parties latérales intérieures 46 des inserts locaux 41 et dont les coins sont engagés dans leurs nervures intérieures 43, la plaque transparente 44 s'étendant en avant et à distance de la face avant du composant semi-conducteur 28 et les fils de connexion électrique 15 passant entre la face avant du composant semi-conducteur 28 et la face arrière de la plaque transparente 44.

La présente invention ne se limite pas aux exemples ci-dessus décrits. Bien des variantes de réalisation sont possibles sans sortir du cadre défini par les revendications annexées.

## Revendications

1. Boîtier semi-conducteur, comprenant des moyens de support et de connexion électrique (2) présentant, dans une face avant, un évidement (4) et un composant semi-conducteur (8) placé dans ledit évidemment et dont une face avant comprend un capteur (10), un espace (12) séparant la périphérie dudit composant semi-conducteur et la périphérie dudit évidement, **caractérisé par le fait qu'**il comprend des moyens de positionnement et de blocage (14 ; 33 ; 41) dudit composant semi-conducteur sur lesdits moyens de montage et de connexion, engagés dans ledit espace (12) et permettant de maintenir la face arrière dudit composant semi-conducteur en appui contre le fond dudit évidement.

2. Boîtier selon l'une quelconque des revendications précédentes, **caractérisé par le fait que** lesdits moyens de positionnement et de blocage comprennent au moins un insert (14 ; 33 ; 41) coopérant avec la partie périphérique dudit composant semi-conducteur et la partie périphérique dudit évidement.

3. Boîtier selon l'une quelconque des revendications 1 et 2, **caractérisé par le fait que** lesdits moyens de positionnement et de blocage comprennent au moins une partie (35) engagée dans au moins un trou (36) ménagé dans le fond dudit évidement (4).

4. Boîtier selon l'une quelconque des revendications précédentes, **caractérisé par le fait que** lesdits moyens de positionnement et de blocage comprennent une partie latérale (37) en appui sur la face avant dudit composant semi-conducteur (28).

5. Boîtier selon l'une quelconque des revendications précédentes, **caractérisé par le fait que** lesdits moyens de positionnement et de blocage comprennent une partie latérale (38) en appui sur la face avant desdits moyens de support et de connexion (2).

6. Boîtier selon l'une quelconque des revendications précédentes, **caractérisé par le fait que** lesdits moyens de positionnement et de blocage comprennent au moins un insert (14) auto-bloqué par coincement dans ledit espace (12).

7. Boîtier selon l'une quelconque des revendications précédentes, **caractérisé par le fait que** lesdits moyens de positionnement et de blocage comprennent au moins un insert (33 ; 41) collé auxdits moyens de montage et de connexion.

8. Boîtier selon l'une quelconque des revendications 4 et 5, **caractérisé par le fait qu'**une couche de colle (38) est interposée entre ladite partie latérale et ladite face avant dudit composant semi-conducteur et/ou desdits moyens de support et de connexion.

9. Boîtier selon l'une quelconque des revendicatios précédentes, **caractérisé par le fait que** lesdits moyens de positionnement et de blocage comprennent un insert annulaire (14) auto-bloqué par coincement dans un espace annulaire séparant la périphérie dudit composant semi-conducteur et la périphérie dudit évidement.

10. Boîtier selon l'une quelconque des revendicatios précédentes, **caractérisé par le fait que** la paroi périphérique (7) dudit évidement (4) est en contre-dépouille

11. Boîtier selon l'une quelconque des revendicatios précédentes, **caractérisé par le fait que** ledit insert est en un matériau élastique.

12. Boîtier selon l'une quelconque des revendicatios précédentes, **caractérisé par le fait qu'**il comprend des moyens d'encapsulation (18, 20 ; 43) de la face avant dudit composant semi-conducteur.

13. Boîtier selon la revendication 12, **caractérisé par le fait que** lesdits moyens d'encapsulation comprennent une bague fixée sur la face avant desdits moyens de support et de connexion et une plaque en un matériau transparent située à distance de la face avant dudit composant semi-conducteur et fixée sur ladite bague.

14. Boîtier selon la revendication 12, **caractérisé par le fait que** lesdits moyens d'encapsulation comprennent une plaque en un matériau transparent placée à distance de la face avant dudit composant semi-conducteur et fixée sur lesdits moyens de positionnement et de blocage.

## Claims

1. Semiconductor package, comprising electrical connection and support means (2) having, in a front face, a recess (4) and a semiconductor component (8) and, a front face of which comprises a sensor (10) placed in the said recess a space (12) separating the periphery of the said semiconductor component from the periphery of the said recess, **characterized in that** it comprises means (14; 33; 41) for positioning and locking the said semiconductor component onto the said connection and support means, engaged in the said space (12) and enabling the rear face of the said semiconductor component to be kept pressed against the bottom of the said recess.

2. Package according to the preceding claim, **characterized in that** the said positioning and locking means comprise at least one insert (14; 33; 41) cooperating with the peripheral part of the said semiconductor component and with the peripheral part of the said recess.

3. Package according to either of Claims 1 and 2, **characterized in that** the said positioning and locking means comprise at least one part (35) engaged in at least one hole (36) made in the bottom of the said recess (4).

4. Package according to any one of the preceding claims, **characterized in that** the said positioning and locking means comprise a side part (37) pressing on the front face of the said semiconductor component (28).

5. Package according to any one of the preceding claims, **characterized in that** the said positioning and locking means comprise a side part (38) pressing on the front face of the said connection and support means (2).

6. Package according to any one of the preceding claims, **characterized in that** the said positioning and locking means comprise at least one insert (14) which is self-locked by being wedged into the said space (12).

7. Package according to any one of the preceding claims, **characterized in that** the said positioning and locking means comprise at least one insert (33; 41) adhesively bonded to the said connection and support means.

8. Package according to either of Claims 4 and 5, **characterized in that** a layer of adhesive (38) is inserted between the said side part and the said front face of the said semiconductor component and/or the said connection and support means.

9. Package according to any one of the preceding claims, **characterized in that** the said positioning and locking means comprise an annular insert (14) which is self-locked by being wedged into an annular space separating the periphery of the said semiconductor component from the periphery of the said recess.

10. Package according to any one of the preceding claims, **characterized in that** the peripheral wall (7) of the said recess (4) is undercut.

11. Package according to any one of the preceding claims, **characterized in that** the said insert is made of an elastic material.

12. Package according to any one of the preceding claims, **characterized in that** it comprises means (18, 20; 43) for encapsulating the front face of the said semiconductor component.

13. Package according to Claim 12, **characterized in that** the said encapsulation means comprise a ring fastened to the front face of the said connection and support means and a plate made of a transparent material located at a distance from the front face of the said semiconductor component and fastened to the said ring.

14. Package according to Claim 12, **characterized in that** the said encapsulation means comprise a plate made of a transparent material placed at a distance from the front face of the said semiconductor component and fastened to the said positioning and locking means.

## Patentansprüche

1. Halbleiter-Gehäuse mit Träger- und elektrischen Anschlußeinrichtungen (2), das in einer Vorderfläche eine Aussparung (4) und ein in der Aussparung angeordnetes Halbleiter-Bauteil (8) aufweist, dessen Vorderfläche einen Sensor (10) aufweist, wobei ein Zwischenraum (12) die Peripherie des Halbleiter-Bauteils und die Peripherie der Aussparung separiert, **dadurch gekennzeichnet, daß** es in dem Zwischenraum (12) eingesetzte und die Rückfläche des Halbleiter-Bauteils an dem Boden der Aussparung haltende Positionierungs- und Sicherungseinrichtungen (14; 33; 41) zum Positionieren und Sichern des Halbleiter-Bauteils an den Montage- und Anschlußeinrichtungen aufweist.

2. Gehäuse nach einem der vorstehenden Ansprüche, **dadurch gekennzeichnet, daß** die Positionierungs- und Sicherungseinrichtungen mindestens einen Einsatz (14; 33; 41) aufweisen, der mit dem peripheren Teil des Halbleiter-Bauteils und dem peripheren Teil der Aussparung zusammenwirkt.

3. Gehäuse nach einem der Ansprüche 1 und 2, **dadurch gekennzeichnet, daß** die Positionierungs- und Sicherungseinrichtungen mindestens einen Teil (35) aufweisen, der in mindestens ein in dem Boden der Aussparung (4) ausgespartes Loch (36) eingreift.

4. Gehäuse nach einem der vorstehenden Ansprüche, **dadurch gekennzeichnet, daß** die Positionierungs- und Sicherungseinrichtungen mindestens einen an der Vorderfläche des Halbleiter-Bauteils (28) anliegenden seitlichen Teil (37)aufweisen.

5. Gehäuse nach einem der vorstehenden Ansprüche, **dadurch gekennzeichnet, daß** Positionierungs- und Sicherungseinrichtungen mindestens einen an der Vorderfläche der Träger- und elektrischen Anschlußeinrichtungen (2) anliegenden seitlichen Teil (38) aufweisen.

6. Gehäuse nach einem der vorstehenden Ansprüche, **dadurch gekennzeichnet, daß** die Positionierungs- und Sicherungseinrichtungen mindestens einen in dem Zwischenraum (12) selbstsichernd eingeklemmten Einsatz (14) aufweisen.

7. Gehäuse nach einem der vorstehenden Ansprüche, **dadurch gekennzeichnet, daß** die Positionierungs- und Sicherungseinrichtungen mindestens einen mit den Montage- und Anschlußeinrichtungen klebend verbundenen Einsatz (33; 41) aufweisen.

8. Gehäuse nach einem der Ansprüche 4 und 5, **dadurch gekennzeichnet, daß** eine Klebstoffschicht (38) zwischen dem seitlichen Teil und der Vorderfläche des Halbleiter-Bauteils und/oder der Träger- und Anschlußeinrichtungen angeordnet ist.

9. Gehäuse nach einem der vorstehenden Ansprüche, **dadurch gekennzeichnet, daß** die Positionierungs- und Sicherungseinrichtungen einen ringförmigen Einsatz (14) aufweisen, der in einem die Peripherie des Halbleiter-Bauteils und die Peripherie der Aussparung separierenden ringförmigen Zwischenraum selbstsichernd eingeklemmt ist.

10. Gehäuse nach einem der vorstehenden Ansprüche, **dadurch gekennzeichnet, daß** die periphere Wand (7) der Aussparung (4) hinterschnitten ist.

11. Gehäuse nach einem der vorstehenden Ansprüche, **dadurch gekennzeichnet, daß** der Einsatz aus einem elastischen Material besteht.

12. Gehäuse nach einem der vorstehenden Ansprüche, **dadurch gekennzeichnet, daß** es Einkapselungseinrichtungen (18, 20; 43) zum Einkapseln der Vorderfläche des Halbleiter-Bauteils aufweist.

13. Gehäuse nach Anspruch 12, **dadurch gekennzeichnet, daß** die Einkapselungseinrichtungen einen an der Vorderfläche der Träger- und Anschlußeinrichtungen befestigten Ring und eine Platte aus einem transparenten Material aufweisen, die von der Vorderfläche des Halbleiter-Bauteils beabstandet ist und an dem Ring befestigt ist.

14. Gehäuse nach Anspruch 12, **dadurch gekennzeichnet, daß** die Einkapselungseinrichtungen eine Platte aus einem transparenten Material aufweisen, die von der Vorderfläche des Halbleiter-Bauteils beabstandet ist und an den Positionierungs- und Sicherungseinrichtungen befestigt ist.
